# EUROPÄISCHE PATENTSCHRIFT

(11) **EP 3 601 875 B1**
(45) Veröffentlichungstag und Bekanntmachung des Hinweises auf die Patenterteilung: **16.12.2020**
(21) Anmeldenummer: 18714422.5
(22) Anmeldetag: 09.03.2018
(51) Int. Cl.: H01S 5/02, H01S 5/00, F21S 41/16, G02B 19/00, G02B 27/09, F21S 41/19, F21S 41/25, F21S 41/176, F21S 45/48, G02B 26/08, G02B 26/10

(54) **LASERMODUL FÜR EINEN FAHRZEUGSCHEINWERFER**
LASER MODULE FOR A VEHICLE HEADLAMP
MODULE LASER POUR UN PHARE DE VÉHICULE

(30) Priorität: 30.03.2017 AT 502542017
(43) Veröffentlichungstag der Anmeldung: 05.02.2020
(73) Patentinhaber: ZKW Group GmbH, 3250 Wieselburg (AT)
(72) Erfinder: MAYER, Matthias, 3240 Mank (AT)
(74) Vertreter: Patentanwaltskanzlei Matschnig & Forsthuber OG
(86) Internationale Anmeldenummer: PCT/AT2018/060062
(87) Internationale Veröffentlichungsnummer: WO 2018/176073

(56) Entgegenhaltungen:
- WO-A1-2011/040290
- AT-A1- 515 375
- CN-U- 201 741 389
- JP-A- 2008 097 808
- JP-A- 2009 021 135
- US-A- 4 986 634
- US-A1- 2007 247 728

## Beschreibung

Die Erfindung betrifft ein Lasermodul für einen Fahrzeugscheinwerfer, mit einer Laser-Lichtquelle, vorzugsweise Laserdiode, und einer der Laser-Lichtquelle zugeordneten Optik umfassend zumindest einen Kollimator. Die Erfindung betrifft des Weiteren eine Laserquellenanordnung für einen Fahrzeugscheinwerfer mit einem Lasermodul und einem Lagerbauteil zur Lagerung des Lasermoduls. Ebenso betrifft die Erfindung ein Lichtmodul, das eine Anzahl dieser Laserquellenanordnung beinhaltet, und einen Fahrzeugscheinwerfer mit einem Lichtmodul und/oder Laserquellenanordnungen dieser Art.

Der Einsatz von Laser-Lichtquellen in Kraftfahrzeugen, insbesondere für Scheinwerfer von Kraftfahrzeugen, hat gegenwärtig an Bedeutung gewonnen, da Laserdioden flexiblere und effizientere Lösungen ermöglichen, wodurch auch die Leuchtdichte des Lichtbündels sowie die Lichtausbeute erheblich gesteigert werden kann. Demgemäß sind die hier betrachteten Laserlichtquellen in erster Linie Laserdioden.

Bei derzeit bekannten Lösungen wird der Laserstrahl allerdings nicht direkt aus der Beleuchtungsvorrichtung bzw. dem Scheinwerfer emittiert, um eine Gefährdung der Augen von Menschen und anderen Lebewesen durch den extrem gebündelten Lichtstrahl hoher Leistung zu vermeiden. Der Laser-Strahl wird vielmehr auf ein zwischengeschaltetes Konversionselement gerichtet, das ein Material zur Luminenszenzkonversion, kurz "Phosphor" genannt, enthält und das Laserlicht, beispielsweise einer Wellenlänge im blauen Bereich, in sichtbares Licht, vorzugsweise weißes Licht, umwandelt; dieses sichtbare Licht wird dann nach außen gelenkt. Im Rahmen der vorliegenden Erfindung wird unter "Phosphor" ganz allgemein ein Stoff oder eine Stoffmischung verstanden, welche Licht einer Wellenlänge in Licht einer anderen Wellenlänge oder eines Wellenlängengemisches, insbesondere in "weißes" Licht, umwandelt, was auch unter dem Begriff "Wellenlängenkonversion" subsumierbar ist. Zumeist ist dem Konversionselement ein programmiert verschwenkbarer Spiegel vorgeschaltet (hinsichtlich des Strahlengangs des Laserlichts), durch den der Laser-strahl auf verschiedene Orte auf dem flächigen Konversionselement gelenkt werden kann. Um zu erreichen, dass auf dem Konversionselement wohldefinierte Lichtflecken oder (bei bewegtem Spiegel) Lichtmuster erzeugt werden, wird das von der Laserlichtquelle herrührende Licht mittels einer optischen Anordnung kollimiert, die hier als Kollimatoroptik bezeichnet wird. Die Kollimatoroptik ist in der Regel unmittelbar nach der Laserlichtquelle (hinsichtlich des Strahlengangs) angeordnet und kann mehrere optische Bauelemente und/oder das Licht begrenzende Komponenten umfassen, ist jedoch häufig durch eine einzelne optische Linse gebildet.

Aufgrund fertigungsbedingter Abweichungen der relativen Lage und Ausrichtung der optischen Komponenten, die zu der Laserlichtquelle gehören, ist es erforderlich, die Laserlichtquelle hinsichtlich des Strahlengangs des von ihr erzeugten Laserstrahls so einzustellen, dass ein Lichtfleck mit gewünschter Schärfe auf dem Konversionselement erzeugt werden kann.

Herkömmliche Lösungen sehen eine Vorrichtung vor, die eine Justierungsmöglichkeit der Kollimatorlinse vorsehen, insbesondere durch Verkippen der Linse gegenüber der optischen Achse oder Verstellen des Abstandes zur Laserlichtquelle (siehe z.B. die Druckschrift AT 515375 A1). Diese Vorrichtungen sind jedoch naturgemäß kompliziert aufgebaut und daher kosten- und zeitaufwendig bei der Herstellung und der Justierung. Zudem führen sie aufgrund der Anzahl der benötigten Komponenten in der Regel zu einem gesteigerten Platzbedarf.

Es ist daher ein Ziel der Erfindung, eine Laserquellenanordnung mit Lasermodulen zu schaffen, die die genannten Nachteile überwindet und im Besonderen ein einfaches und effizientes Einstellen des Laser-Strahlenganges gestattet. Insbesondere soll bei Lichtmodulen mit mehreren Laserlichtquellen ein individuelles Einstellen der einzelnen Laserstrahlen ermöglicht werden.

Diese Aufgabe wird durch ein Lasermodul der eingangs genannten Art gelöst, welches erfindungsgemäß einen Modulkörper mit einem Kopfteil hat, welcher einen Gelenkteil eines Kugelgelenks mit zumindest einer Gelenkfläche mit kugelschalenartiger Formgebung beinhaltet, wobei die Laserlichtquelle zusammen mit der Optik in einem in dem Kopfteil vorgesehenen Aufnahmeraum (d.h. ein zumindest teilweise umschlossener Bereich im Kopfteil) in fester Lagebeziehung zueinander montiert sind.

Ebenso wird die Aufgabe durch eine Laserquellenanordnung (Laserbaugruppe) für einen Fahrzeugscheinwerfer mit einem Lasermodul nach der Erfindung und mit einem Lagerbauteil zur Lagerung dieses Lasermoduls gelöst, wobei das Lagerbauteil einen Gelenkteil aufweist, der mit zumindest einer Gelenkfläche mit kugelschalenartiger Formgebung als Gegenstück zum Gelenkteil des Kopfteils des Lasermoduls ausgebildet ist, wobei die Gelenkteile des Kopfteils und des Lagerbauteils zueinander korrespondierend zum Ausbilden eines Kugelgelenks ausgebildet sind.

Die Erfindung beruht auf der Erkenntnis, dass es für eine Korrektur des Strahlganges nicht erforderlich ist, den Kollimator gegenüber der Lichtquelle zu verstellen; vielmehr reicht es aus, die Einheit, die die Lichtquelle und den Kollimator enthält, als Ganzes zu justieren. Gemäß der erfindungsgemäßen Lösung beinhaltet das Lasermodul einen Modulkörper mit einem Kopfteil, der einen inneren Bereich als Aufnahmeraum aufweist, in dem die Laserquelle, d.h. die Laserdiode und die zugehörende Kollimatoroptik, feststehend montierbar sind. Die Laserdiode und der Kollimator befinden sich somit in einer festen Lagebeziehung zueinander; diese bilden zusammen mit dem sie aufnehmenden Modulkörper eine Einheit, innerhalb der die darin befindlichen Komponenten nach der Montage in der Regel nicht mehr geändert werden. Der Kopfteil bildet einen Gelenkteil eines Kugelgelenks mit zumindest einer kugelschalenartigen Gelenkfläche; ein zweites Gelenkteil des Kugelgelenks gehört zu einem Lagerbauteil, das der einstellbaren Lagerung des Lasermoduls dient. Das erfindungsgemäße Lasermodul und das Lagerbauteil bilden zusammen eine Laserbaugruppe, nämlich die Laserquellenanordnung der Erfindung, die formschlüssig vormontiert werden kann und in der die beiden Teile durch die Gelenkverbindung nicht mehr auseinander fallen. Das durch die beiden Gelenkteile gebildete Kugelgelenk ermöglicht ein einfaches und effizientes Einstellen der Ausrichtung der Laserquelle bzw. des von dieser erzeugten Laserstrahls und des zugehörenden Strahlengangs. Die so erreichte Justierung des Lasermoduls kann sodann durch eine dauerhafte Befestigung, z.B. mittels Kleben oder Punktschweißung, fixiert werden.

Durch das Justieren der Laserbaugruppe gleich am Beginn des Strahlenganges können alle gegebenenfalls auftretenden Abweichungen sowie die Toleranzen der nachfolgenden optischen Flächen optischer Komponenten kompensiert werden; die im Strahlengang nachfolgenden Bauteile müssen daher nicht mehr, oder zumindest nur mehr in deutlich verringertem Umfang, justiert werden. Insbesondere ermöglicht die Erfindung ein effizientes Entgegenwirken gegen propagierenden Fehlern (z.B. Winkelfehler) im Strahlengang.

Im Rahmen dieser Offenbarung bedeutet "optische Komponente" eine Komponente, die der Erzeugung von Licht und/oder dem Umlenken oder Formen von Licht dient, worunter insbesondere Lichtquellen und Licht-konvertierende Bauteile sowie optische Linse, Spiegel und Blenden fallen. Unter "Längsrichtung" wird die Richtung der gedachten Achse verstanden, entlang der die Lichtausbreitung des Laserlichts aus der Laserlichtquelle erfolgt, einschließlich der Verlängerung nach rückwärts, d.h. entgegen der Ausbreitungsrichtung des Lichts.

In der Regel wird der Modulkörper zumindest einen Kühlteil aufweisen, der insbesondere der Ableitung von Wärme von der Lichtquelle dient. Dieser Kühlteil kann günstiger Weise von dem Kopfteil des Modulkörpers abgewandt angeordnet sein. Des Weiteren kann der Kühlteil sich parallel zu der Längsrichtung erstrecken, d.h. jener Richtung, die eine rückwärtige Verlängerung der nominellen Richtung ist, entlang der von der Lichtquelle erzeugtes Laserlicht aus dem Aufnahmeraum austritt.

Um das Montieren der Laserlichtquelle und der ihr zugehörenden elektrischen Versorgung zu erleichtern, ist es vorteilhaft, wenn das Kühlteil, bzw. zwei oder mehr der genannten Kühlteile, um einen Zugangsweg herum angeordnet sind, durch welcher ein Zugang zu einem Montageort, in dem die Laserlichtquelle montierbar ist, gebildet ist. Der Zugangsweg kann insbesondere mit der Längsrichtung zusammenfallen, jedoch auch von dieser abweichen. Zudem kann die Laserlichtquelle durch den Zugang in den Modulkörper einsetzbar sein, beispielsweise in einen von der Rückseite her zugänglichen Sitz, der für die Laserlichtquelle vorgesehen ist.

Vorzugsweise kann das Kugelgelenk so vorgesehen sein, dass die Gelenkfläche des Kopfteils zumindest einen konvex geformten Teil einer Kugelschale aufweist (Kugelkopf); im Gegenstück ist dann z.B. eine Gelenkpfanne vorgesehen, die zumindest einen konkav geformten Teil einer Kugelschale aufweist. Alternativ dazu können die Rollen auch vertauscht sein, d.h. das Gegenstück beinhaltet einen Kugelkopfteil und der Kopfteil des Lasermoduls beinhaltet eine Gelenkfläche, die zumindest einen konkav geformten Teil einer Kugelschale aufweist.

Um nach dem Einsetzen und gegebenenfalls Justieren die (justierte) Position des Lasermoduls in der Laserquellenanordnung sichern zu können, kann nach dem Ausbilden des Kugelgelenks und Einjustieren der Orientierung des Lasermoduls eine unlösbare Fixierung der Position des Kopfteils an einem über die Gelenkfläche verbundenen Gegenstück hergestellt werden. Diese Fixierung kann insbesondere durch Kleben oder bevorzugt einen Schweißpunkt erreicht werden.

Der Aufnahmeraum kann zweckmäßiger Weise als eine Vertiefung im Kopfteil ausgebildet sein, in welcher die Laserlichtquelle zusammen mit der Optik dauerhaft montierbar ist. Hierbei kann die Vertiefung zudem in einer in der Gelenkfläche vorgesehenen Öffnung münden, die für den Durchtritt von in der Laserlichtquelle erzeugtem Laserlicht vorgesehen ist.

In einer anderen Ausgestaltung der Erfindung kann der Kopfteil zwei oder mehr Vorsprünge aufweisen, die den Aufnahmeraum umgebend angeordnet sind.

Eine zweckmäßige Position der Laserlichtquelle zusammen mit der Optik innerhalb des Aufnahmeraums ist z.B. derart, dass die virtuelle Lichtquelle (d.h. der Ort der Emission, von dem der Laserstrahl scheinbar ausgeht, hinsichtlich des Strahlenganges unmittelbar nach der Laserlichtquelle und darin integrierten Optik) in dem Mittelpunkt der Gelenkfläche des Kopfteils angeordnet ist. Durch diese Maßnahme wird vermieden, dass sich die virtuelle Lichtquelle bei der Justierung verschiebt.

Gemäß einer günstigen Formgebung entspricht die kugelartig gekrümmte Gelenkfläche einem Kugelschalenteil, der in Bezug auf eine Längsachse innerhalb einer Winkelbreite liegt, die kleiner ist als ein Montagewinkel der Verdrehung um die Längsachse, wobei diese Bedingung nur für jenen Teil / für zumindest jenen Teil der Gelenkfläche gilt, der hinsichtlich der Längsachse der Laserlichtquelle abgewandt ist. Dieser Montagewinkel ist vorzugsweise 90°. Die Ränder der Gelenkfläche können günstiger Weise stetig, vorzugsweise glatt, in den restlichen Teil des Kopfteils und/oder den Kühlteil übergehen.

Die Erfindung wird in näheren Einzelheiten und weiteren Vorzügen anhand der nachstehend dargestellten Ausführungsbeispiele weiter verständlich. Die Ausführungsbeispiele betreffend in beispielhafter und nicht einschränkender Weise verschiedene Ausgestaltungen von Lichtmodulen und Lasermodulen in einem KFZ-Scheinwerfer, die in schematischer Form in den beigefügten Zeichnungen dargestellt sind, worin:
- Fig. 1: ein Lichtmodul gemäß einem ersten Ausführungsbeispiel zeigt;
- Fig. 2: illustriert den optischen Strahlengang und die optischen Komponenten in dem Lichtmodul der Fig. 1;
- Fig. 3: zeigt ein Lasermodul des Lichtmoduls der Fig. 1 und eine zugeordnete Lagerung in einer perspektivischen Ansicht von schräg vorne;
- Fig. 4: zeigt das Lasermodul der Fig. 3 in einer anderen perspektivischen Ansicht von schräg hinten;
- Fig. 5: zeigt eine perspektivische Schnittansicht des Lasermoduls der Fig. 3 und 4;
- Fig. 6: zeigt ein Beispiel eines dejustierten Strahlengangs eines Lasermoduls;
- Fig. 7: illustriert die erfindungsgemäße Korrektur des Strahlengangs des Lasermoduls der Fig. 6;
- Fig. 8a und 8b: veranschaulichen die erfindungsgemäße Korrektur anhand der durch das Lichtmodul erzeugten Lichtbilder, wobei Fig. 8a ein gewünschtes Lichtbild zeigt und Fig. 8b ein Lichtbild mit einem dejustierten Lichtstreifen;
- Fig. 9: zeigt in einer perspektivischen Ansicht ein Lasermodul und eine zugeordnete Lagerung gemäß einem anderen Ausführungsbeispiel;
- Fig. 10: zeigt das Lasermodul der Fig. 9 in einer weiteren perspektivischen Ansicht; und
- Fig. 11: illustriert den Montagevorgang des Lasermoduls der Fig. 7.

In den Figuren und in der nachstehenden Diskussion der Ausführungsbeispiele sind für die Erfindung in einem Fahrzeugscheinwerfer wichtige Teile dargestellt, wobei klar ist, dass ein Fahrzeugscheinwerfer noch viele andere, nicht gezeigte Teile enthält, die einen sinnvollen Einsatz in einem Fahrzeug selbst ermöglichen. Der Übersichtlichkeit halber sind daher beispielsweise das Scheinwerfergehäuse, die Ansteuerungselektronik, weitere mechanische Elemente beziehungsweise Halterungen optischer Komponenten in dem Fahrzeugscheinwerfers nicht gezeigt; diese hier nicht dargestellten Komponenten können von dem Fachmann ohne Weiteres aus dem Stand der Technik ergänzt werden.

Zudem versteht sich, dass die in den Ansprüchen verwendeten Bezugszeichen lediglich die Lesbarkeit der Ansprüche und das Verständnis der Erfindung erleichtern sollen und keinen den Schutzumfang der Erfindung einschränkenden Charakter haben.

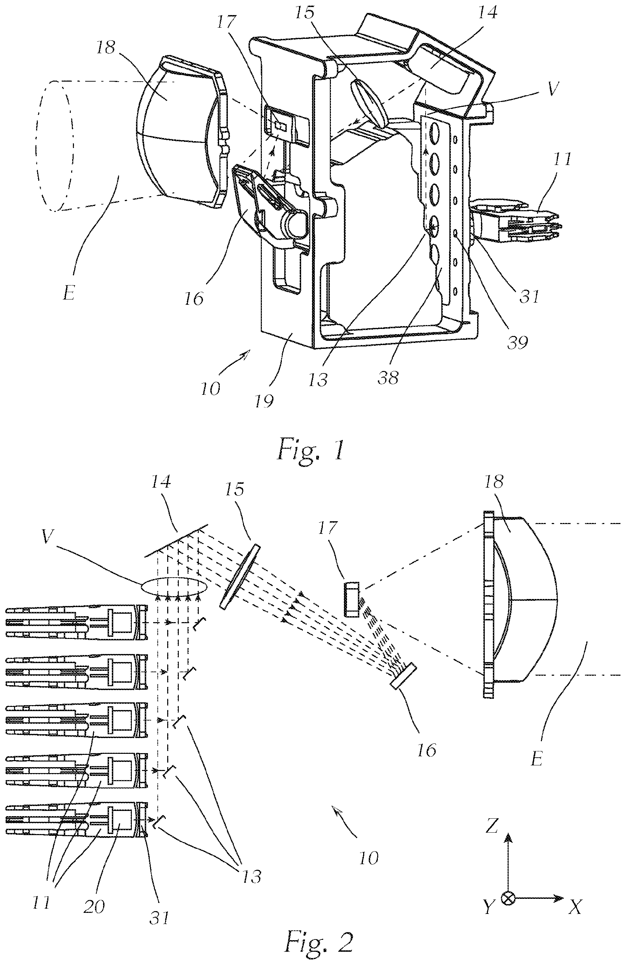

Die Fig. 1 bis 7 illustrieren ein erstes Ausführungsbeispiel der Erfindung, nämlich ein Lichtmodul 10 eines KFZ-Scheinwerfers. In Fig. 1 ist das Lichtmodul 10 mit eröffnetem Gehäuse 19 gezeigt, wodurch eine Übersicht der wesentlichen optischen Komponenten des Lichtmoduls 10 ersichtlich ist. Fig. 2 zeigt die optischen Komponenten des Lichtmoduls 10 und den Strahlengang mehrerer Laserstrahlen, der durch diese Komponenten definiert wird.

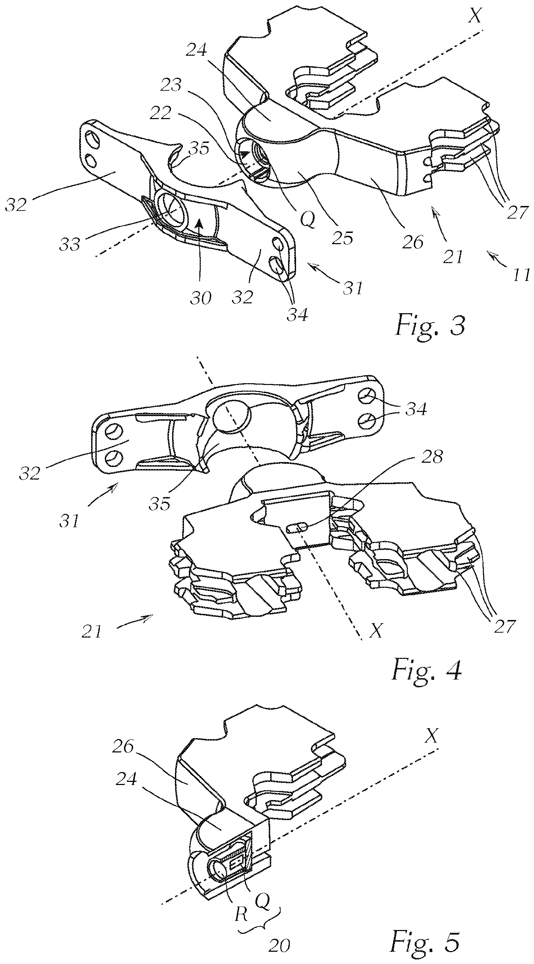

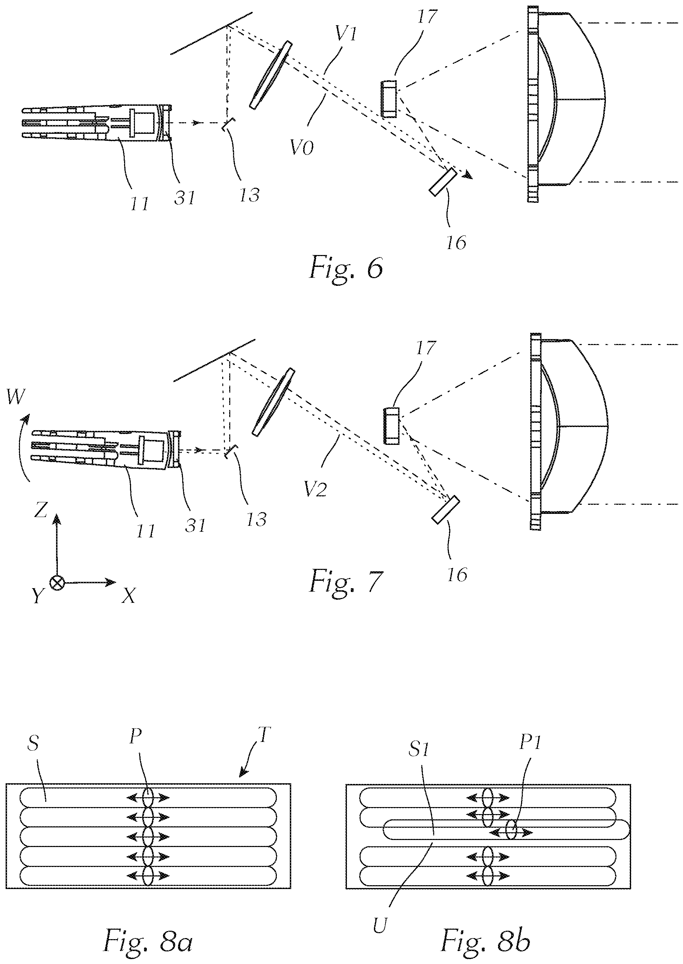

Das Lichtmodul 10 beinhaltet eine Anzahl Lasermodule 11 (z.B. zwei bis fünf, allgemeiner ein bis zehn oder mehr, je nach der gewählten Ausführungsvariante), wie insbesondere in Fig. 2 erkennbar ist. Jedes Lasermodul 11 enthält jeweils eine Laserlichtquelle Q (Fig. 5), die in dem gezeigten Beispiel als Laserdiode ausgebildet ist; jedoch sind andere Laserquellen bekannter Art in entsprechender Weise verwendbar. Die Lasermodule 11 sind beispielsweise in dem Lichtmodul 10 in einer linearen Anordnung entlang einer Richtung Z neben- oder übereinander aufgereiht, beispielsweise an einem hierfür vorgesehenen Montagefeld 38 an der Außenseite des Gehäuses 19 mithilfe von Lagerelementen 31 des Lichtmoduls 10 befestigt, wie weiter unten näher erläutert wird. Jedem Lasermodul 11 ist je einer aus einer entsprechenden Anzahl von ersten Umlenkspiegel 13 zugeordnet, die entlang einer Richtung Z gestaffelt angeordnet sein können, welche Richtung Z quer zur der Längsrichtung X der Ausstrahlung des Laserlichts aus den Lasermodulen 11 orientiert ist. Das Licht, das von je einer der Lasermodule 11 ausgesandt wird, wird durch dem jeweils zugeordneten ersten Umlenkspiegel 13 umgelenkt, wodurch ein Strahlenbündel V entsteht, das auf eine dynamische Strahlablenkeinrichtung 16, z.B. in Form eines MEMS-Scanner-Spiegels, geleitet wird, beispielsweise mithilfe eines im Strahlengang zwischengeschalteten zweiten Umlenkspiegels 14 und einer Linse 15, und/oder eines (nicht gezeigten) Hohlspiegels, z.B. Parabolspiegel. Die Strahlablenkeinrichtung 16 lenkt periodisch, wie nachstehend erläutert wird, das Licht des Strahlenbündels auf einen Phosphor 17. Das so auf dem Phosphor 17 erzeugte Lichtbild wird mithilfe einer Projektionsoptik, die im gezeigten Ausführungsbeispiel z.B. durch eine Projektionslinse 18 verwirklicht ist, nach außen - hinausgehendes Bild E - durch die (nicht gezeigte) Frontscheibe des Scheinwerfers projiziert, wo es beispielsweise auf einer Fahrbahn ein gewünschtes Lichtbild (vgl. Fig. 8a, 8b) erzeugt.

Die Strahlablenkeinrichtung 16 ist in dem hier betrachteten Ausführungsbeispiel als um zumindest eine Achse steuerbar verschwenkbarer Mikrospiegel ausgeführt, der z. B. mithilfe der bekannten MEMS-Technologie (Micro-Electro-Mechanical Systems) hergestellt ist und somit auch als MEMS-Scanner bekannt ist. Ein Mikrospiegel dieser Art (oder jeder von mehreren Mikrospiegeln) wird beispielsweise als eindimensionaler Zeilenscanner eingesetzt, wobei die Laserstrahlen zeilenweise periodisch über den Phosphor gelenkt werden (1D-Scanner). Bei Verwendung mehrerer Laserstrahlen können auf dem Phosphor mehrere Laserpunkte erzeugt werden, die übereinander angeordnet sind, und mit diesen werden unter Verwendung des periodisch schwingenden Mikrospiegels Lichtstreifen erzeugt, die aneinandergrenzen oder überlappen, sodass dazwischen kein Spalt freigelassen wird (vgl. Fig. 8a). In einer Variante kann vorgesehen sein, dass ein Mikrospiegel um 2 Achsen verschwenkt wird, wodurch mehrere Laserstrahlen einen Punkt auf den Phosphor erzeugen, der zeilenweise über den Phosphor gescannt wird (2D Scanner).

Fig. 3 zeigt ein Lasermodul 11 sowie ein zugeordnetes Lagerelement 31 des Lichtmoduls 10 in einer perspektivischen Ansicht. Fig. 4 zeigt das Lasermodul 11 in einer anderen perspektivischen Ansicht, worin die Blickrichtung um ca. 90° gegenüber der Fig. 3 gedreht ist. Fig. 5 zeigt das Lasermodul 11 in einer Schnittansicht längs einer Ebene, die durch die Längsrichtung X verläuft und parallel zur Richtung Z liegt.

Das Lasermodul 11 wird von einem Modulkörper 21 gebildet, in dem die bereits erwähnte Laserlichtquelle Q montiert ist und einen der Laserlichtquelle Q zugeordneten Kollimator (Kollimatoroptik) R vorgesehen ist; beispielsweise kann der Kollimator R durch eine einzelne Sammellinse (Kollimatorlinse) verwirklicht sein, die im Strahlgang unmittelbar nach der Lichtquelle Q angeordnet und dort fest montiert oder einstellbar gehalten ist. Der Modulkörper 21 kann einstückig ausgebildet sein oder gegebenenfalls aus mehreren Teilen zusammengefügt sein. In dem in Fig. 3 bis 5 gezeigten Ausführungsbeispiel sind die Laserlichtquelle Q und eine dieser nachgeschaltete Kollimatorlinse R in einer vormontierten Laserdiodeneinheit 20 untergebracht. In dieser sind die Lichtquelle Q und der Kollimator R in einer definierten Lage zueinander eingebaut. Beispielsweise kann als Laserdiodeneinheit 20 eine Laserdiode verwendet werden, in deren Bauteilgehäuse eine Laserdiode und ein Fenster, das den Laserstrahl austreten lässt und als Kollimatorlinse dienen kann, untergebracht sind und von der ein elliptischer Laserstrahl ausgesendet wird.

Die Laserdiodeneinheit 20 ist in einer hierfür vorgesehenen Vertiefung 22 in dem Lasermodul 11 eingesetzt und dort fixiert. Hierbei kann z.B. der Boden der Vertiefung 22 oder ein Vorsprung (z. B. eine ringförmige Stufe) in der Seitenwand der Vertiefung einen Sitz für die Einheit 20 bilden. Auf diese Weise sind Lichtquelle Q und Kollimator R starr in dem Modulkörper 21 angeordnet. Das von der Laserdiodeneinheit 20 abgestrahlte Licht tritt durch die der Vertiefung 22 entsprechenden Öffnung 23 an der Oberfläche des Modulkörpers 21 aus. Die Öffnung 23 bzw. die zugehörende Vertiefung 22 befindet sich vorzugsweise in einem an der Vorderseite des Lasermoduls ausgebildeten Kopfteil 24, der eine Formgebung mit einer Gelenkfläche 25 aufweist, die im gezeigten Beispiel konvex kugelschalenartig ausgebildet ist und durch die dem Kopfteil ermöglicht ist, ein Kugelgelenk in Verbindung mit einem geeigneten Gegenstück (insbesondere dem Lagerelement 31) herzustellen. Vorzugsweise befindet sich die Vertiefung 22 an einem Scheitelpunkt des Kopfteils 24, parallel zur Längsrichtung X des Lasermoduls 11, beispielsweise in der Mitte der Gelenkfläche 25. Die Öffnung 23 ist bevorzugt kreisförmig, kann jedoch gegebenenfalls anders gestaltet sein. Die Länge des Modulkörpers 21 (entlang der Längsrichtung X) liegt typischer Weise bei 5 cm. Die Laserdiodeneinheit 20 ist in der Vertiefung 22 vorzugsweise so angeordnet, dass sich die virtuelle Lichtquelle (d.h. der Emissionspunkt des Laserstrahls) im Mittelpunkt der kugelschalenartig gekrümmten Gelenkfläche 25 befindet. Die Vertiefung 22 ist zudem so geformt, dass ein guter Wärmeübergang von dem Bauteilgehäuse der Laserdiodeneinheit 20 in den Modulkörper 21 stattfinden kann. In dem Ausführungsbeispiel der Fig. 3-5 wird die Laserdiodeneinheit 20 bei ihrer Montage in das Lasermodul von vorne, beispielsweise durch die Öffnung 23, in die Vertiefung 22 des Modulkörpers 21 eingesetzt, wobei die elektrischen Anschlüsse (nicht gezeigt) durch eine oder mehrere hierfür vorgesehene Durchführungen 28 (Fig. 4) im Boden der Vertiefung zur Rückseite des Modulkörpers 21 geführt werden können.

Das Lasermodul 11 wird mithilfe des Kopfteils 24 in ein Lagerbauteil 31 eingesetzt und kann dort fixiert werden, wodurch eine Laserquellenanordnung im Sinne der Erfindung gebildet wird. Der Lagerbauteil der hier dargestellten Ausführungsformen ist ein einstückiges Lagerelement; in anderen Ausführungsvarianten kann der Lagerbauteil auch aus mehreren Teilen zusammengesetzt sein.

Bezugnehmend auf Fig. 3 und 4 weist das Lagerelement (Lagerbauteil) 31 eine Gelenkpfanne 30 auf, die als zweites Gelenkteil das Gegenstück für den Kopfteil 24 zum Herstellen einer Gelenkverbindung nach Art eines Kugelgelenks bildet. Die Gelenkpfanne 30 weist eine Gelenkfläche 35 auf, die im gezeigten Beispiel als konkav gekrümmte Kugelschale ausgebildet ist, genauer gesagt als Teilfläche dieser konkaven Kugelschale (Kugelinnenfläche). Korrespondierend dazu hat die Gelenkfläche 25 des Kopfteils 24 die Form einer konvexen Kugelschale, genauer gesagt eines Teils einer Kugelschale (Kugelaußenfläche). Die beiden Gelenkflächen 25, 35 sind zueinander korrespondierend geformt, sodass die Kugelinnenfläche in der Kugelaußenfläche drehbar positionierbar ist und eine Lagerung mit Kugelgelenk bildet.

Das Lagerelement 31 weist außerdem Befestigungseinrichtungen wie z.B. Laschen 32 auf, die zum dauerhaften Befestigen des Lagerelements 31 an hierfür vorgesehenen Montageflächen 38 des Lichtmoduls 10 dienen, beispielsweise mittels Schrauben oder Nieten (nicht gezeigt), die durch in den Laschen 32 vorgesehen Löcher 34 hindurchgeführt und aufseiten der Montageflächen 38 durch korrespondierende Löcher 39 (Fig. 1) fixiert werden. Zudem ist in der Gelenkpfanne 30 zweckmäßiger Weise eine Öffnung 33 vorgesehen, die mit der Öffnung 23 des Kopfteil 24 korrespondiert und durch die das von der Lichtquelle Q ausgesandte Laserlicht hindurchtreten kann.

Im gezeigten Ausführungsbeispiel entspricht die Gelenkfläche 25 jenem Teil einer Kugelkalotte, der oben und unten (in Bezug auf die Höhenrichtung Z) beschnitten worden ist, sodass die oberhalb und unterhalb liegenden Teile entfallen, und aus dem zudem die Öffnung 23 ausgenommen worden ist. Die Schnittebenen entsprechen den zwei zur Höhenrichtung Z senkrechten XY-Ebenen auf der Höhe der oberen bzw. unteren Kante des Kopfteils 24. Die Gelenkfläche 35 weist eine analoge Formgebung auf, wobei jedoch die Höhe in Z-Richtung und/oder die Größe oder Formgebung der Gelenkfläche 35 geringfügig abweichen kann, sofern dies mit der Anordnung an den Montageflächen des Lichtmoduls kompatibel ist.

Bekanntermaßen wird in der Lichtquelle Q bzw. der Laserdiodeneinheit 20 während deren Betrieb Wärme erzeugt, und diese muss abgleitet werden, um eine Zerstörung der Lichtquelle zu vermeiden. Die Wärmeableitung erfolgt über den Modulkörper 21 des Lichtmoduls. Wieder bezugnehmend auf Fig. 3 und 4 gelangt die Wärme über den Kopfteil 24 und an diesem anschließende Seitenteile 26 zu Kühlrippen 27, mithilfe deren die Wärme an die Umgebung abgegeben wird. Die Kühlrippen 27 sind z.B. als äußere Ausbildungen des Modulkörpers verwirklicht, die vorzugsweise an einer Rückseite des Lasermoduls angeordnet sind, d.h. auf einer dem Kopfteil 24 abgewandten Seite. In der in Fig. 3 und 4 gezeigten Ausführungsform weist der Modulkörper 21 des Lasermoduls 11 zwei flügelartige Seitenteile 26 auf, die beiderseits der Längsrichtung X ausgebildet sind und zueinander beabstandet sind, wodurch entlang der Längsrichtung X ein Zugang zu der Hinterseite des Kopfteils gebildet ist. Die Kühlrippen 27 sind hierbei in der Verlängerung der Seitenteile 26 nach rückwärts vorgesehen. Dadurch ergibt sich eine abgeflachte Bauform des Lasermoduls 11, die eine Anordnung einer Anzahl von Lasermodulen in einer (oder gegebenenfalls mehreren) Reihe erleichtert, die beispielsweise - bevorzugt linear - entlang der Richtung Z ausgerichtet ist, die quer zur Ausbreitungsrichtung X des Laserlichtes liegt, beispielsweise in vertikaler Richtung.

Idealerweise verläuft der Laserstrahl, der aus der in dem Lasermodul 11 montierten Lichtquelle (d.h. in diesem Fall der Laserdiodeneinheit 20) austritt, entlang einer in dem Lasermodul 11 definierten Längsrichtung X. Die Montage und grundsätzliche Ausrichtung des Lasermoduls 11 in dem Lichtmodul 10 wird aufgrund diese Längsrichtung X durchgeführt, wodurch der aus der Lichtquelle austretende Laserstrahl sich - zumindest näherungsweise - in eine definierte Richtung und entlang des vorgegebenen Strahlengangs (vgl. Fig. 2) ausbreitet. Tatsächlich jedoch tritt, wie nachstehend erläutert wird, eine Abweichung der Austrittsrichtung von der Längsrichtung X auf und somit ein gewisser Fehler des Strahlengangs.

Aufgrund von Toleranzen und/oder Montagefehlern in der Lichtquelle Q bzw. der Laserdiodeneinheit 20 und der Halterung derselben in dem Lasermodul, beispielsweise aufgrund von Abweichungen der Formgebung in der Vertiefung 22, kann die Richtung des austretenden Laserstrahls von der der Längsrichtung X geringfügig abweichen.

Das Lasermodul 11 wird in Abhängigkeit von der Austrittsrichtung des Laserstrahl innerhalb des Lichtmoduls 10 ausgerichtet, damit das Licht gemäß der im Lichtmodul 10 vorgegebenen Richtung (Richtung X in Fig. 2) zu dem zugeordneten ersten Umlenkspiegel 13 gelenkt wird. Um die Austrittsrichtung des Lichtes einzustellen, wird die bereits genannte Gelenkverbindung verwendet, die durch die Gelenkpfanne 30 des Lagerelements 31 und den darin eingesetzten Kopfteil 24 gebildet wird.

In Fig. 6 und 7 ist der Vorgang des Einstellens eines Lasermoduls 11 am Beispiel eines Strahlengangs eines Lasermoduls in einem Lichtmodul der in Fig. 1 und 2 gezeigten Art veranschaulicht. Fig. 6 zeigt ein Lasermodul 11 im anfänglichen Zustand unmittelbar nach seinem Einbau in das Lagerelement 31. Toleranzen (oder andere Abweichungen) an den Bauteilen, insbesondere optischen Komponenten, des Lichtmoduls 10 können im optischen Pfad zu einer Abweichung von dem Soll-Strahlengang V0 (strichlierte Linie) führen, wie in Fig. 6 symbolisch durch eine punktierte Linie V1 dargestellt; diese Abweichung (Dejustierung) kann häufig so groß sein, dass der Laserstrahl auf einen falschen Ort des Mikrospiegels (Strahlablenkeinrichtung) 16 fällt oder diesen ganz verfehlt. Erfindungsgemäß erlaubt das Kugelgelenk des Lasermoduls 11 ein Verkippen des Lasermoduls um einen kleinen Winkel von der nominellen Achse X, was in Fig. 7 durch den Pfeil W angedeutet ist. Die Richtung, in die Verkippung erfolgt, kann in der Z-Richtung (innerhalb der Zeichnungsebene der Fig. 7; einschließlich der Gegenrichtung) und/oder senkrecht dazu - in die Richtung Y senkrecht zur Zeichnungsebene - liegen. Auf diese Weise wird ermöglicht, dass die Richtung des aus dem Lasermodul austretenden Laserstrahls korrigiert wird und so ein korrigierter Strahlengang V2 erzielt wird, mit dem das Laserstrahl wie erfordert auf die Mikrospiegelanordnung 16 und den Phosphor 17 gelenkt wird.

Das Justieren der Lasermodule kann zudem automatisiert durchgeführt werden. Hierzu wird das vormontierte Lasermodul 11 am hinteren Ende des Kühlkörpers gehalten, z.B. von einem Roboter. Mittels einer Kamera wird der Leuchtpunkt, der durch das Lasermodul 11 erzeugt wird, auf dem Phosphor 17 gemessen; aufgrund dieser Messung wird eine allfällige Abweichung bestimmt, und demgemäß die Ausrichtung des Lasermoduls 11 nachjustiert, bis die Position des Leuchtpunkts mit der Sollposition übereinstimmt. Auf diese Weise werden alle Abweichungen / Toleranzen im Strahlengang kompensiert.

Im Gegensatz zu herkömmlichen Lösungen, in denen nur die der Laserlichtquelle nachfolgende Linse (Kollimator) verstellt wird, sieht die vorliegende Erfindung vor, dass die Laserlichtquelle einschließlich der Kollimatoroptik - die in den gezeigten Ausführungsbeispielen zudem in der Laserdiodeneinheit integriert ist - justiert wird. Hierbei kann zudem vorgesehen sein, dass die Lichtquelle nicht nur geschwenkt, sondern auch gedreht werden kann (nämlich durch Drehen des Lasermoduls). Das ermöglicht ein Drehen eines elliptischen Laser-Ausgangsstrahls, was bei herkömmlichen Lösungen, in denen nur die Linse justiert wird, nicht möglich ist.

Um das Lasermodul 11 in der justierten Lage zu sichern, wird es mit Hilfe einer Fixiereinrichtung in dieser Lage fixiert. Hierzu wird, vorteilhafterweise direkt anschließend an den oben beschriebenen Justiervorgang, ein Schweißpunkt durch die Gelenkpfanne 30 hindurch bis zur Gelenkfläche 25 gesetzt. Hierbei wird die Wand der Kugelschale durch den Schweißvorgang (bevorzugt Laserschweißen) im Bereich des Schweißpunkts vorübergehend erhitzt und dadurch aufgeschmolzen; auf diese Weise verbindet sich das Gelenkteil mit dem darunterliegenden Gegenstück. Dadurch wird das durch die beiden Gelenkteile 24, 35 gebildete Kugelgelenk dauerhaft in dieser Position fixiert; zugleich wird die Gelenkverbindung selbst gegen unerwünschtes Lösen gesichert. Während des Vorgangs des Fixierens wird die Position zweckmäßiger Weise durch geeignete Haltemittel (wie z.B. einen Roboterarm, mithilfe dessen auch die Justierung des Lasermoduls 11 vorgenommen wird) gehalten. Alternativ kann eine dauerhafte Fixierung auch durch andere Mittel erzielt werden, beispielsweise durch einen Klebstoff, der z. B. in den Gelenkspalt eingebracht wird oder zuvor ein- oder beidseitig auf die Kugelfläche(n) aufgebracht wird. In diesem Fall wird die Anordnung zusammengesetzt, justiert und so lange in der justierten Position gehalten, bis der Klebstoff ausgehärtet ist, sei diese durch Selbsthärtung oder dadurch, dass der Klebstoff z.B. mittels UV-Bestrahlung ausgehärtet wird.

Die Wirkung der Erfindung ist in Fig. 8a und 8b nochmals, anhand des auf dem Phosphor 17 ausgeleuchteten Bereichs, erläutert; dieser ausgeleuchtete Bereich wird mit dem ihm aufmodulierten Helligkeitsverlauf als Lichtbild T vor den Scheinwerfer auf die Fahrbahn projiziert. Fig. 8a zeigt ein gewünschtes Lichtbild T, das aus einer Vielzahl von Streifen S besteht, die durch die Scan-Bewegung der Mikrospiegel der Mikrospiegelanordnung 16 erzeugt werden, indem jeweils ein Lichtpunkt P, der von einem Laserstrahl erzeugt wird, einen der Streifen S ausleuchtet. Die Doppelpfeile symbolisieren hierbei die Scan-Richtung der Lichtpunkte P im Lichtbild T; der Helligkeitsverlauf, der einer konkreten Lichtverteilung entspricht, ist der Deutlichkeit halber in Fig. 8a und 8b nicht dargestellt, vielmehr ist ein (hypothetisches) einheitlich helles Lichtbild angenommen. Die einzelnen Streifen S verlaufen zueinander parallel, wobei sie aneinander grenzen oder geringfügig überlappen. Wenn eines der Lasermodule dejustiert ist, ist der durch den zugehörenden dejustierten Lichtpunkt P1 erzeugte Streifen S1 wie in Fig. 8b dargestellt gegenüber seiner Sollposition verschoben, wobei diese Verschiebung im Allgemeinen eine Komponente entlang der Scan-Richtung sowie eine Komponente quer zu dieser (Querversatz) aufweisen kann. Insbesondere als Auswirkung des Querversatzes kommt es dazu, dass ein mehr oder weniger schmaler streifenförmiger Bereich U nicht ausgeleuchtet wird, was zu einer Unterbrechung in dem Lichtbild führt. Durch die erfindungsgemäße Justierungsmöglichkeit des Lichtmoduls kann diese Verschiebung und eine sich daraus gegebenenfalls ergebende Unterbrechung des Lichtbildes auf einfache Weise kompensiert werden, sodass das einheitlich ausgeleuchtete Lichtbild T der Fig. 8a wieder erhalten werden kann.

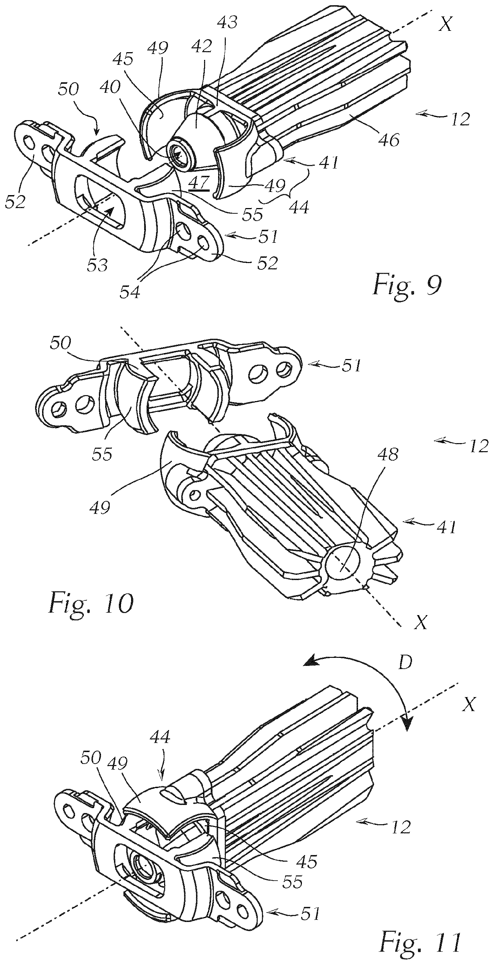

Die Fig. 9 und 10 zeigen ein Lasermodul 12 und ein zugehörendes Lagerelement 51 gemäß einem weiteren Ausführungsbeispiel, das eine besonders stabile formschlüssige Gelenkverbindung erlaubt. Das Lasermodul 12 ist wiederum durch einen Modulkörper 41 gebildet, der sich in einen Kopfteil 44 und einen Kühlteil 46 gliedert. In den Kopfteil 44 ist eine Laserdiodeneinheit 40 mit der Laserlichtquelle Q und integriertem Kollimator R aufgenommen. In der gezeigten Ausführungsform beinhaltet der Kopfteil 44 einen Sitz 42, der vorzugsweise mittig auf einer Grundplatte 43 des Modulkörpers 41 angeordnet und in dem die Laserdiodeneinheit 40 aufgenommen und gehalten wird, beispielsweise in Form einer Vertiefung in einer kegelstumpfförmigen Halterung. Der Sitz 42, und somit die Lichtquelle Q bzw. die Laserdiodeneinheit 40, liegt in der Mitte eines Innenbereichs 47 des Kopfteils 44, der von der Grundplatte 43 und zwei seitlich auf dieser angeordneten Vorsprüngen 49 definiert wird und der dem Aufnahmeraum der Erfindung entspricht. Jeder Vorsprung 49 weist an seiner Innenseite, d.i. die der Lichtquelle Q bzw. dem Sitz 42 zugeordnete Seite, je eine konkav gekrümmte Kugelinnenfläche 45 auf, die als Gelenkfläche eines Gelenkteils zum Ausbilden eines Kugelgelenks dient. Unter Kugelinnenfläche wird hier, wie bereits erwähnt, eine konkav gekrümmte Kugelschalen-Teilfläche verstanden. Die Laserdiodeneinheit 40 befindet sich im montierten Zustand in dem Sitz 42 bevorzugt in einer derartigen Position, dass sich die virtuelle Lichtquelle (d.h. der Emissionspunkt des Laserstrahls) im Mittelpunkt der (kugelschalenartigen) Gelenkfläche 45 befindet.

Der Kühlteil 46 schließt sich an die Grundplatte 43 des Kopfteils an, wobei er sich in Längsrichtung X gesehen nach hinten von dem Kopfteil 44 erstreckt. An der Außenseite des Kühlteils ist eine Vielzahl von Kühlrippen ausgebildet, die z.B. ebenfalls in Längsrichtung verlaufen. Günstiger Weise ist in der Mitte des Kühlteils 46, entlang der Längsachse X eine Zugangsöffnung 48 freigelassen. Die Montage der Laserdiodeneinheit 40 in den Modulkörper 41 erfolgt durch Einsetzen der Einheit 40 durch diese rückseitige Zugangsöffnung 48. Diese Zugangsöffnung 48 dient zudem der Zuführung der elektrischen Versorgung der Laserdiodeneinheit 40.

Das zum Lasermodul 12 korrespondierende Lagerelement 51 weist einen Gelenkteil 50 auf, der als zweites Gelenkteil das Gegenstück für den Kopfteil 44 zum Herstellen einer Gelenkverbindung nach Art eines Kugelgelenks bildet. Das Gelenkteil 50 ist als Kugelkopf, genauer gesagt in Form von Teilen eines Kugelkopfes, ausgebildet und beinhaltet im gezeigten Beispiel zwei Vorsprünge, deren Außenseiten jeweils eine Gelenkfläche 55 aufweisen. Die Gelenkflächen 55 sind Kugelaußenflächen, d.h. Teilflächen konvexer Kugelschalenflächen. Die beiden Gelenkflächen 45, 55 sind zueinander korrespondierend geformt, sodass sie eine Lagerung gemäß einem Kugelgelenk bilden können, in dem die Kugelinnenfläche in der Kugelaußenfläche drehbar einstellbar ist.

Das Lagerelement 51 weist außerdem Befestigungseinrichtungen wie z.B. Laschen 52 auf, die zum dauerhaften Befestigen des Lagerelements 51 an hierfür vorgesehenen Montageflächen des Lichtmoduls 10 dienen, beispielsweise mittels Schrauben oder Nieten (nicht gezeigt), die durch in den Laschen 52 vorgesehen Löcher 54 hindurchgeführt und aufseiten der Montageflächen des Lichtmoduls 10 fixiert werden. Zudem ist zweckmäßiger Weise eine Öffnung 53 vorgesehen, die mit der Vorderseite des Innenbereichs 47 korrespondiert und durch die das von der Lichtquelle Q ausgesandte Laserlicht hindurchtreten kann.

Im gezeigten Ausführungsbeispiel entsprechen die beiden Flächen 45 jenen Teilen eines um die Längsrichtung X verlaufenden Kugelzonenrings, der oben und unten (in Bezug auf die Höhenrichtung Z) beschnitten worden ist, sodass die oberhalb und unterhalb liegenden Teile entfallen. Die Schnittebenen entsprechen den zwei zur Höhenrichtung Z senkrechten XY-Ebenen auf der Höhe der oberen bzw. unteren Kante der Grundplatte 43.

Die Gelenkflächen 55 können geometrisch auch als (kleiner) Teil eines Kugelschalensektors einer gedachten Kugel angesehen werden, der in Bezug auf die Längsachse X eine Winkelbreite einnimmt, die kleiner ist als ein vorgegebener Montagewinkel der Verdrehung D um die Längsachse X. Dieser Montagewinkel ist vorzugsweise 90°, kann gegebenenfalls aber auch abweichend gewählt werden, insbesondere kleiner. Auf diese Weise kommen die Gelenkflächen 55, wenn das Lasermodul um diesen Montagewinkel um die Längsachse X gedreht wird, in Bereiche der gedachten Kugel zu liegen, die an keiner Stelle mit den Bereichen überlappen, die die Gelenkflächen vor der Drehung eingenommen hatten. Dies ermöglicht, dass die Gelenkflächen 55 in der ursprünglichen Position im Eingriff mit dem Gegenstück stehen, während sie in der gedrehten Position frei sind und ein Einsetzen bzw. Entnehmen des Lasermoduls zulassen. Ergänzend wird angemerkt, dass diese Einschränkung hinsichtlich des Winkelbreite streng genommen nur für den dem Gegenstück 50 abgewandten Teil gilt (oder, mit anderen Worten, dem der Lichtquelle Q abgewandten Teil), während für die dem Gegenstück 50 zugewandten Teile der Gelenkflächen keine derartige Einschränkung gilt, wie dies am Beispiel der ersten Ausführungsform erkennbar ist.

Durch diese Gestaltung sind die Gelenkflächen der beiden Gelenkteile so geformt, dass das Lasermodul auf dem Lagerelement aufgesetzt und durch eine Drehbewegung formschlüssig in einer Weise, die ein Auseinanderfallen des Kugelgelenks verhindert, verbunden werden kann. Dadurch kann die sichere Verbindung des Lasermoduls im Lichtmodul erreicht werden, die gleichwohl eine einfache und dauerhafte Justierung zulässt.

Fig. 11 illustriert den Vorgang des Einsetzens des Lasermoduls 12 auf das Lagerelement 51, um die entsprechende Laserquellenanordnung mit einer Kugelgelenkverbindung zu erhalten. Vorausgesetzt sei, dass das Lagerelement 51 bereits an den hierfür vorgesehen Montageflächen des Lichtmoduls montiert ist - dies ist in Fig. 11 der Deutlichkeit halber nicht gezeigt. Das Lasermodul 12 wird mit dem Kopfteil voran, entlang der Längsachse X ausgerichtet, jedoch um diese um einen Winkel von z.B. 90° (Montagewinkel) gedreht, zum Lagerelement 51 hin bewegt. Auf diese Weise stehen die Vorsprünge 49 des Kopfteils 44 einerseits und die des korrespondierenden Gelenkteils 50 andererseits einander nicht im Weg, sodass das Lasermodul 12 entlang der Längsrichtung X bis in die in Fig. 11 gezeigte Position gebracht werden kann, bei der die Kugelschalenteile konzentrisch sind. Durch eine Drehung D des Lasermoduls 41 um die Achse X um 90° (Montagewinkel) werden die Gelenkflächen 45, 55 in Eingriff gebracht, und eine Gelenkverbindung ist hergestellt, die ein Verkippen des Lasermoduls um (nicht zu große) Winkel zulässt, ohne dass die Gelenkverbindung selbst dadurch aufgelöst wird.

Die Justierung des Lasermoduls 41 hinsichtlich des Strahlengangs entspricht dem Vorgang, der weiter oben anhand der Fig. 6 und 7 im Zusammenhang mit dem ersten Ausführungsbeispiel erläutert wurde. Zum Fixieren der Lasermoduls in der justierten Position können auch hier Schweißpunkte oder andere geeignete Mittel eingesetzt werden.

Selbstverständlich ist die Erfindung nicht auf die oben beschriebenen Ausführungsbeispiele beschränkt; vielmehr sind vielfältige Abwandlungen im Rahmen der Erfindung wie durch die Ansprüche definiert denkbar. Insbesondere kann die Orientierung des Lichtmoduls und der darin angeordneten Lasermodule anders sein als hier gezeigt; so kann beispielsweise die Höhenrichtung Z auch horizontal statt vertikal ausgerichtet sein. Die Längsrichtung X der Lasermodule ist meist horizontal, kann jedoch auch anders orientiert sein; jedoch ist im Lichtmodul naturgemäß die Ausrichtung der Mikrospiegelanordnung, Projektionslinse und Phosphor gemäß der Einbaulage im Scheinwerfer vorgegeben, um die Projektion eines Lichtbildes nach vorne durch den Scheinwerfer zu gewährleisten. Auch können die an dem Kugelgelenk beteiligten Kugelinnen- und -außenflächen der beiden Gelenkteile in der erfindungsgemäßen Laserquellenanordnung wahlfrei so angeordnet sein, dass die Kugelinnenflächen in dem Kopfteil des Modulkörpers und die Kugelaußenflächen auf dem Lagerelement angeordnet sind, oder umgekehrt die Kugelaußenflächen auf dem Kopfteil und die Kugelinnenflächen im Lagerelement.

## Patentansprüche

1. Lasermodul (11, 12) für einen Fahrzeugscheinwerfer, mit einer Laserlichtquelle (Q), vorzugsweise Laserdiode, und einer der Laserlichtquelle zugeordneten Optik umfassend zumindest einen Kollimator (R), **gekennzeichnet durch** einen Modulkörper (21, 41) mit einem Kopfteil (24, 44), welcher einen Gelenkteil eines Kugelgelenks mit zumindest einer Gelenkfläche (25, 45) mit kugelschalenartiger Formgebung beinhaltet, wobei die Laserlichtquelle (Q) zusammen mit der Optik (R) in einem in dem Kopfteil (24) vorgesehenen Aufnahmeraum (22, 47) in fester Lagebeziehung zueinander montiert sind.

2. Lasermodul nach Anspruch 1, **dadurch gekennzeichnet, dass** der Modulkörper (21, 41) zumindest einen Kühlteil (26, 46) aufweist, der von dem Kopfteil (24, 44) des Modulkörpers abgewandt angeordnet ist.

3. Lasermodul nach Anspruch 2, **dadurch gekennzeichnet, dass** der zumindest eine Kühlteil (26, 46) sich parallel zu einer Achsrichtung (X) erstreckt, die eine rückwärtige Verlängerung der nominellen Richtung ist, entlang der von der Lichtquelle (Q) erzeugtes Laserlicht aus dem Aufnahmeraum (22, 47) austritt.

4. Lasermodul nach Anspruch 2 oder 3, **dadurch gekennzeichnet, dass** zwei oder mehr der genannten Kühlteile (26) um einen Zugangsweg (X) herum angeordnet sind, durch welcher ein Zugang (28, 48) zu einem Montageort, in dem die Laserlichtquelle (Q) montierbar ist, gebildet ist.

5. Lasermodul nach Anspruch 4, **dadurch gekennzeichnet, dass** die Laserlichtquelle (Q) durch den Zugang (48) in den Modulkörper (41) einsetzbar ist.

6. Lasermodul nach einem der vorhergehenden Ansprüche, **dadurch gekennzeichnet, dass** die Gelenkfläche (25) des Kopfteils zumindest einen konvex geformten Teil einer Kugelschale aufweist.

7. Lasermodul nach einem der Ansprüche 1 bis 6, **dadurch gekennzeichnet, dass** der Aufnahmeraum (22) als eine Vertiefung (22) im Kopfteil (24) ausgebildet ist, in welcher die Laserlichtquelle (Q) zusammen mit der Optik (R) dauerhaft montierbar sind, wobei die Vertiefung in eine in der Gelenkfläche vorgesehenen Öffnung (23) mündet, die für den Durchtritt von in der Laserlichtquelle (Q) erzeugtem Laserlicht vorgesehen ist.

8. Lasermodul nach einem der Ansprüche 1 bis 6, **dadurch gekennzeichnet, dass** der Kopfteil (44) zwei oder mehr Vorsprünge (49) aufweist, die den Aufnahmeraum (47) umgebend angeordnet sind, wobei die Laserlichtquelle (Q) zusammen mit der Optik (R) innerhalb des Aufnahmeraums in oder nahe einem Mittelpunkt der Gelenkfläche (25, 45) des Kopfteils angeordnet ist.

9. Lasermodul nach einem der vorhergehenden Ansprüche, **dadurch gekennzeichnet, dass** die zumindest eine Gelenkfläche (55) einem Kugelschalenteil entspricht, der in Bezug auf eine Längsachse (X) innerhalb einer Winkelbreite liegt, die kleiner ist als ein Montagewinkel der Verdrehung um die Längsachse (X), wobei der Montagewinkel vorzugsweise 90° ist, wobei dies für zumindest jenen Teil der Gelenkfläche (55) gilt, der hinsichtlich der Längsachse (X) der Laserlichtquelle (Q) abgewandt ist.

10. Laserquellenanordnung für einen Fahrzeugscheinwerfer mit einem Lasermodul (11, 12) nach einem der vorhergehenden Ansprüche, und mit einem Lagerbauteil (31, 51) zur Lagerung des Lasermoduls, wobei das Lagerbauteil einen Gelenkteil (30, 50) aufweist, der mit zumindest einer Gelenkfläche (35, 55) mit kugelschalenartiger Formgebung als Gegenstück zum Gelenkteil des Kopfteils (24,44) des Lasermoduls ausgebildet ist, wobei die Gelenkteile des Kopfteils und des Lagerbauteils zueinander korrespondierend zum Ausbilden eines Kugelgelenks ausgebildet sind.

11. Laserquellenanordnung nach Anspruch 10, **gekennzeichnet durch** eine nach dem Ausbilden des Kugelgelenks hergestellte, unlösbare Fixierung der Position des Kopfteils (24, 44) an einem über die Gelenkfläche (25, 45) verbundenen Gegenstück (30, 50).

12. Lichtmodul (10) umfassend eine Anzahl von Laserquellenanordnungen nach Anspruch 10 oder 11.

13. Fahrzeugscheinwerfer mit einem Lichtmodul nach Anspruch 12 und/oder zumindest einer Laserquellenanordnung nach Anspruch 10 oder 11.

## Claims

1. Laser module (11, 12) for a vehicle headlamp, comprising a laser light source (Q), preferably a laser diode, and an optical system assigned to the laser light source and comprising at least one collimator (R), **characterised by** a module body (21, 41) having a head portion (24, 44), which includes an articulation part of a ball-and-socket joint having at least one articulation surface (25, 45) of spherical shell shape, wherein the laser light source (Q) is mounted together with the optical system (R) in a fixed positional relationship to each another within a receiving space (22, 47) provided in the head portion (24).

2. Laser module according to claim 1, **characterised in that** the module body (21, 41) includes at least one cooling portion (26, 46) which is arranged facing away from the head portion (24, 44) of the module body.

3. Laser module according to claim 2, **characterised in that** the at least one cooling portion (26, 46) extends parallel to an axial direction (X) which is a rearward extension of the nominal direction along which laser light generated by the light source (Q) exits from the receiving space (22,47).

4. Laser module according to claim 2 or 3, **characterised in that** two or more of said cooling portions (26) are arranged around an access pathway (X) which forms an access (28, 48) to a mounting location in which the laser light source (Q) is mountable.

5. Laser module according to claim 4, **characterised in that** the laser light source (Q) is insertable into the module body (41) through the access (48).

6. Laser module according to any one of the preceding claims, **characterised in that** the articulation surface (25) of the head portion has at least one convex-shaped portion of a spherical shell.

7. Laser module according to any one of the claims 1 to 6, **characterised in that** the receiving space (22) is realized as a recess (22) in the head portion (24), in which the laser light source (Q) together with the optical system (R) is mountable permanently, wherein the recess opens into an opening (23) provided in the articulation surface, which opening is provided for allowing passage of laser light generated in the laser light source (Q).

8. Laser module according to any one of claims 1 to 6, **characterised in that** the head portion (44) comprises two or more projections (49) which are arranged surrounding the receiving space (47), wherein the laser light source (Q) together with the optical system (R) is arranged within the receiving space in or close to a center of the articulation surface (25, 45) of the head portion.

9. Laser module according to any one of the preceding claims, **characterised in that** the at least one articulation surface (55) corresponds to a spherical shell component which, with respect to a longitudinal axis (X), lies within an angular width which is smaller than a mounting angle of rotation about the longitudinal axis (X), the mounting angle preferably being 90°, this applying to at least that part of the articulation surface (55) which faces away from the laser light source (Q) with respect to the longitudinal axis (X).

10. Laser source assembly for a vehicle headlamp, comprising a laser module (11, 12) according to one of the preceding claims and a bearing component (31, 51) configured to support the laser module, the bearing component comprising an articulation part (30, 50) realized to have at least one articulation surface (35, 55) of spherical shell shape as a counterpart to the articulation part of the head portion (24, 44) of the laser module, the articulation parts of the head portion and the bearing component being realized corresponding to one another so as to form a ball joint.

11. Laser source assembly according to claim 10, **characterised by** a non-releasable fixing of the position of the head portion (24, 44) at a counterpart (30, 50) connected via the articulation surface (25, 45), which fixing is produced after formation of the ball joint.

12. Light module (10) comprising a number of laser source arrangements according to claim 10 or 11.

13. Vehicle headlamp comprising a light module according to claim 12 and/or at least one laser source assembly according to claim 10 or 11.

## Revendications

1. Module laser (11, 12) pour un projecteur de véhicule, comportant une source de lumière laser (Q), de préférence une diode laser, et un système optique associé à la source de lumière laser et comportant au moins un collimateur (R), **caractérisé par** un corps de module (21, 41) avec une partie de tête (24, 44), qui comprend une partie d'articulation d'une articulation sphéroïde avec au moins une surface d'articulation (25, 45) ayant une forme de coque sphérique, la source de lumière laser (Q) étant montée avec le système optique (R) en relation de position fixe l'une par rapport à l'autre dans un espace de réception (22,47) prévu dans la partie de tête (24).

2. Module laser selon la revendication 1, **caractérisé en ce que** le corps de module (21, 41) comprend au moins une partie de refroidissement (26, 46) qui est disposée à l'opposé de la partie de tête (24, 44) du corps de module.

3. Module laser selon la revendication 2, **caractérisé en ce que** ladite au moins une partie de refroidissement (26, 46) s'étend parallèlement à une direction axiale (X) qui est une extension vers l'arrière de la direction nominale le long de laquelle la lumière laser générée par la source de lumière (Q) sort de l'espace de réception (22, 47).

4. Module laser selon la revendication 2 ou 3, **caractérisé en ce que** deux ou plusieurs desdits éléments de refroidissement (26) sont disposés autour d'un chemin d'accès (X) par lequel est formé un accès (28, 48) à un emplacement de montage dans lequel la source de lumière laser (Q) peut être montée.

5. Module laser selon la revendication 4, **caractérisé en ce que** la source de lumière laser (Q) peut être insérée dans le corps de module (41) par l'accès (48).

6. Module laser selon l'une quelconque des revendications précédentes, **caractérisé en ce que** la surface d'articulation (25) de la partie de tête comprend au moins une partie de forme convexe d'une coque sphérique.

7. Module laser selon l'une quelconque des revendications 1 à 6, **caractérisé en ce que** l'espace de réception (22) est en forme d'un évidement (22) dans la partie de tête (24), dans lequel la source de lumière laser (Q) avec le système optique (R) peut être montée de manière permanente, l'évidement débouchant dans une ouverture (23) prévue dans la surface d'articulation, ladite ouverture étant conçue pour le passage de la lumière laser générée par la source de lumière laser (Q).

8. Module laser selon l'une quelconque des revendications 1 à 6, **caractérisé en ce que** la partie de tête (44) présente deux ou plusieurs saillies (49) disposées autour de l'espace de réception (47), la source de lumière laser (Q) avec le système optique (R) étant disposée à l'intérieur de l'espace de réception dans ou près d'un point central de la surface d'articulation (25, 45) de la partie de tête.

9. Module laser selon l'une quelconque des revendications précédentes, **caractérisé en ce que** ladite au moins une surface d'articulation (55) correspond à une partie de coque sphérique qui, par rapport à un axe longitudinal (X), se trouve dans une largeur angulaire qui est inférieure à un angle de rotation de montage autour de l'axe longitudinal (X), l'angle de montage étant de préférence de 90°, ceci s'appliquant au moins à la partie de la surface d'articulation (55) qui est opposée à la source de lumière laser (Q) par rapport à l'axe longitudinal (X).

10. Ensemble de source laser pour un projecteur de véhicule comportant un module laser (11, 12) selon l'une quelconque des revendications précédentes, et comportant un élément de support (31, 51) pour supporter le module laser, l'élément de support comprenant une partie d'articulation (30, 50) qui est réalisée avec au moins une surface d'articulation (35, 55) en forme coque sphérique, comme contrepartie de la partie d'articulation de la partie de tête (24, 44) du module laser, les parties d'articulation de la partie de tête et de l'élément de support étant conçues pour correspondre l'une à l'autre afin de former une articulation sphérique.

11. Ensemble de source laser selon la revendication 10, **caractérisé par** une fixation inséparable, produite après la formation de l'articulation sphérique, de la position de la partie de tête (24, 44) à une contrepartie (30, 50) reliée par la surface d'articulation (25, 45).

12. Module d'éclairage (10) comprenant un nombre d'ensembles de source laser selon la revendication 10 ou 11.

13. Projecteur de véhicule comportant un module d'éclairage selon la revendication 12 et/ ou au moins un ensemble de source laser selon la revendication 10 ou 11.
